# EUROPÄISCHE PATENTSCHRIFT

(11) **EP 3 257 965 B1**
(45) Veröffentlichungstag und Bekanntmachung des Hinweises auf die Patenterteilung: **20.06.2018**
(21) Anmeldenummer: 17174218.2
(22) Anmeldetag: 02.06.2017
(51) Int. Cl.: C23C 14/04, C23C 14/50, C23C 16/04, C23C 16/458, B65D 33/16, B65D 75/58

(54) **VERFAHREN UND VORRICHTUNG ZUM BESCHICHTEN VON KUNSTSTOFFAUSGIESSERN**
METHOD AND DEVICE FOR COATING PLASTIC SPOUTS
PROCÉDÉ ET DISPOSITIF DESTINÉS AU REVÊTEMENT DE BECS VERSEURS EN PLASTIQUE

(30) Priorität: 13.06.2016 DE 102016110799
(43) Veröffentlichungstag der Anmeldung: 20.12.2017
(73) Patentinhaber: Waldorf Technik GmbH, 78234 Engen (DE); Cavonic GmbH, 78234 Engen (DE)
(72) Erfinder: CZIZEGG, Wolfgang, 78256 Steisslingen (DE)
(74) Vertreter: Patentanwälte Behrmann Wagner PartG mbB

(56) Entgegenhaltungen:
- EP-A2- 2 518 102
- WO-A1-2015/062806
- JP-A- 2009 292 492

## Beschreibung

Die Erfindung betritt ein Verfahren gemäß dem Oberbegriff des Anspruchs 1 zum Beschichten von, insbesondere durch Spritzgießen hergestellten, vorzugsweise, ggf. bis auf einen separaten, fakultativen Verschlussdeckel, monolithischen, Kunststoffausgießern (Spouts) für Packgut-Verpackungen, insbesondere für Standbeutelverpackungen, umfassend einen eine Sieglefläche zum Festlegen einer Verpackungsbehälterhülle, insbesondere einer Standbeutelfolie, durch, bevorzugt thermisches, Siegeln aufweisenden Fixierabschnitt und einen sich in einer Axialrichtung erstreckenden, den Fixierabschnitt durchsetzenden und, vorzugsweise den Fixierabschnitt axial überragenden, Ausgießkanal, mit einer, insbesondere SiOₓ umfassenden, Barriereschicht im Vakuum zum Erhöhen der Durchtrittssperrwirkung gegen mindestens eine chemische Verbindung und/oder mindestens ein chemisches Element auf einer Innenoberfläche des Ausgießkanals, wobei gleichzeitig eine Vielzahl von Kunststoffausgießern in einer Vakuum-Beschichtungskammer mit der Barriereschicht im Vakuum, vorzugsweise durch ein ALD-Verfahren, ein CVD-Verfahren oder ein PVD-Verfahren beschichtet werden.

Ferner betrifft die Erfindung eine zur Durchführung des vorgenannten Verfahrens geeignete und bestimmte Vorrichtung gemäß dem Oberbegriff des Anspruchs 13, umfassend eine Vakuumbeschichtungskammer (Beschichtungsvorrichtung), die vorzugsweise zur Durchführung eines ALD-Verfahrens, eines CVD-Verfahrens oder eines PVD-Verfahrens ausgebildet und bestimmt ist, zum gleichzeitigen Beschichten einer Vielzahl von Kunststoffausgießern mit einer jeweiligen Barriereschicht im Vakuum, weiter umfassend Handhabungsmittel zum Aufsetzen jeweils mehrerer Verpackungsbehälter auf einen, vorzugsweise auf der Vorrichtung zwischen verschiedenen Stationen umlaufenden Träger (Werkstückträger).

Standbeutelverpackungen sind als Folienverpackungsbehälter für Getränke hinlänglich bekannt. Zum Ausgießen des bevorrateten Getränks umfassen bekannte Standbeutelverpackungen einen sogenannten Spout (Kunststoffausgießer), welcher an der Standbeutelfolie festgesiegelt ist, so dass der Kunststoffausgießer an seinem hierfür vorgesehenen Fixierabschnitt allseitig von der Standbeutelfolie umschlossen ist. Zur Ausleitung des Getränks umfasst der Kunststoffausgießer einen i.d.R. von einem Rohrabschnitt gebildeten Ausgießkanal, welcher auf der Außenseite der Standbeutelverpackung mit einem Verschluss, meist einem Drehverschluss oder einem Siegelverschluss, verschließbar ist.

Zum Schutz des Getränks vor Gasen, insbesondere Sauerstoff, und/oder Feuchtigkeit weisen Standbeutelfolien meist eine Barriereschicht, beispielsweise aus Aluminium auf. Schwachstelle hinsichtlich der Gasdichtheit sind die Kunststoffausgießer (Spouts), die im Regelfall ohne Barriereschicht gefertigt werden.

Dieses Problem wurde bereits in der JP 2009-046 166 A beschrieben. Zur Lösung des Problems wird am Kunststoffausgießer eine im Vakuum aufgebrachte Barriereschicht aus SiOₓ aufgebracht, wobei sich die Barriereschicht gemäß der Lehre der Druckschrift zur Verbesserung der Haptik nicht an der Außenseite des Kunststoffausgießers befinden soll. Daher schlägt die japanische Druckschrift eine mehrteilige Ausbildung des Kunststoffausgießers vor, wobei ein ein Ausgussrohr umfassendes Hauptteil an seiner Außenseite mit der Barriereschicht versehen und dann die Barriereschicht durch ein weiteres, rohrförmiges Bauteil geschützt wird, welches auf die Barriereschicht des Hauptteils aufgeschoben wird. Im Ergebnis befindet sich dann die Barriereschicht nicht an der Außenseite des fertigen Kunststoffausgießers sondern ist sandwichartig zwischen zwei Kunststoffschichten aufgenommen, wobei eine innere dieser Kunststoffschichten, nämlich die das Ausgussrohr des Hauptteils bildende Kunststoffschicht die unbeschichtete Innenoberfläche des Ausgussrohres bildet und mit dem Getränk beim Ausgießen unmittelbar in Kontakt kommt. Nachteilig bei dem bekannten Spout ist dessen Mehrteiligkeit und die damit verbundene komplexe Fertigung bzw. Montage.

Aus dem Stand der Technik sind ferner Verfahren zum Herstellen von Kunststoffverpackungsbehältern bekannt, bei denen Kunststoffverpackungsbehälter durch Spritzgießen, Tiefziehen und/oder Blasformen hergestellt werden. Auch ist es auch dem Stand der Technik bekannt, an den Kunststoffverpackungsbehältern Siegelzonen vorzusehen, an die Verschlussmittel in Form von Siegelfolien gesiegelt werden. Insbesondere dann, wenn in zumindest einer der Kammern ein feuchtigkeits- oder sauerstoffempfindliches Füllgut, insbesondere ein Lebensmittel, Kosmetik oder ein Arzneimittel aufgenommen werden soll ist es wünschenswert, dass der Kunststoffverpackungsbehälter eine Barriereschicht zur Erhöhung der Durchtrittssperrwirkung gegen Feuchtigkeit und/oder Gase aufweist. Solche im Vakuum aufzubringenden Barriereschichten sind beispielsweise in der EP 1 048 746 A1 oder der WO 2009/030425 A1 beschrieben. Nachteilig bei den bekannten Barriereschichten ist es, dass herkömmliche Siegelmaterialien schlecht an diesen haften, was zu einem ungewollten Ablösen von Siegelfolien führen kann, weshalb unter Umständen auf eine solche Beschichtung wegen dieser Nachteile ganz verzichtet wird. Daher ist es (außerhalb der Spout-Technologie) im Rahmen von Kavitäten aufweisenden Verpackungsbehältern aus der EP 2 518 102 A2 bekannt geworden, die Siegelzonen (Siegelflächen) der Verpackungsbehälter während des Beschichtungsvorgangs mit Masken zu verdecken. Hierzu werden die Behälter zunächst auf einen Träger aufgesetzt, woraufhin dann die Maske auf die Verpackungsbehälter aufgesetzt wird, die nach dem Beschichtungsvorgang wieder von den Behältern entnommen wird. Diese Verfahrensweise ist aufgrund des notwendigen Schrittes des Maskenauf- und wieder absetzens komplex und zeitintensiv, jedoch verfahrenstechnisch einfach realisierbar, da sich die Siegelfläche bei Verpackungsbehältern, im Gegensatz zu Spouts auf einer Oberseite befindet, auf die die Maske leicht abgelegt werden kann.

Aus der WO 2015/062806 A1 ist ein Verfahren zum Beschichten von Spouts bekannt geworden, welches ohne Maskierung auskommt und darauf beruht, die Siegelfläche mit einer erhöhten Rauheit auszustatten, so dass die Barriereschicht beim thermischen Siegeln aufbricht und die Siegelfolie in Kontakt mit dem darunter befindlichen Kunststoff kommen kann. Für diese Verfahrensweise werden entweder spezielle, entsprechend aufgeraute Spritzgusswerkzeuge benötigt oder ein zusätzlicher Bearbeitungsschritt zur Aufrauung der Oberfläche.

Die DE 10 2011 052 149 A1 betrifft ein Verfahren zum Beschichten von becherförmigen Verpackungsbehältern mit einer Vakuumbarriereschicht, wobei die Behälter mit einer Bodenseite und nach oben gerichteter Siegelfläche auf einen Träger aufgesetzt und einer Vakuumbeschichtungskammer zugeführt werden. Zum Schutz der Siegelfläche vor einer Beschichtung mit der Vakuumbarriereschicht werden die Siegelflächen mit separaten Masken maskiert.

Die fachfremde DE 601 30 703 T2 beschreibt ein Verfahren und eine Vorrichtung zum Maskieren von mehreren Turbinenteilen.

Ausgehend von dem vorgenannten Stand der Technik liegt der Erfindung die Aufgabe zugrunde, ein vereinfachtes Verfahren zum Beschichten von Kunststoffausgießern für Packgut-Verpackungen, insbesondere Standbeutelverpackungen anzugeben, welches sicherstellt, dass die Spouts nach dem Beschichten im Vakuum an ihrer Siegelfläche thermisch siegelbar sind, ohne die Notwendigkeit, eine aufgeraute Siegeloberfläche vorsehen zu müssen. Auch soll auf die aus der Verpackungsbehältertechnologie bekannten Auf- und Absetzvorgänge von separaten Masken zur Maskierung der seitlichen Siegelflächen verzichtet werden können.

Ferner besteht die Aufgabe darin, eine Vorrichtung zur Durchführung des vereinfachten Verfahrens anzugeben.

Diese Aufgabe wird hinsichtlich des Verfahrens mit den Merkmalen des Anspruchs 1 gelöst, d.h. bei einem gattungsgemäßen Verfahren dadurch, dass die Kunststoffausgießer vor dem Beschichten mit der Barriereschicht derart auf einen Träger aufgesetzt werden, dass die Kunststoffausgießer während der Beschichtung mit ihrer jeweiligen Siegelfläche dem, bevorzugt horizontal ausgerichteten, Träger zur Maskierung gegen eine Beschichtung mit der Barriereschicht zugewandt sind. Anders ausgedrückt wird die seitliche bzw. mantelseitige Siegelfläche des Fixierabschnitts, der vorzugsweise monolithisch (einteilig) mit dem Ausgießkanal ausgebildet ist von dem Träger maskiert, ohne dass es des Einsatzes von Träger separater Siegelflächenmasken bedarf. Ferner ist vorgesehen, dass jedem Kunststoffausgießer ein axialer Durchbruch des Trägers, zugeordnet wird, derart dass die Ausgießkanäle mit den Durchbrüchen fluchten und somit während der Beschichtung im Vakuum Beschichtungsgas und/oder Beschichtungsplasma die Durchgangsöffnungen und Ausgießkanäle durchströmt.

Hinsichtlich der Vorrichtung wird die Aufgabe mit den Merkmalen des Anspruchs 13 gelöst, d.h. bei einer gattungsgemäßen Vorrichtung dadurch, dass die Handhabungsmittel derart ausgebildet sind, dass diese die Spouts derart auf den Träger (der Vorrichtung) aufsetzen, dass die Spouts während der Beschichtung mit ihrer Siegelfläche dem Träger zur Maskierung gegen eine Beschichtung mit der Barriereschicht zugewandt sind (so dass der Träger die Siegelfläche gegen eine Beschichtung mit der Vakuum-Barriereschicht, insbesondere der SiOₓ-Schicht maskiert). Ferner ist vorgesehen, dass die Handhabungsmittel derart ausgebildet sind, dass diese die Kunststoffausgießer derart auf den Träger aufsetzen, dass die Kunststoffausgießer während der Beschichtung mit ihrer Siegelfläche dem Träger zur Maskierung gegen eine Beschichtung mit der Barriereschicht zugewandt sind, und dass der Träger eine Mehrzahl von Durchbrüchen aufweist, die derart ausgebildet und angeordnet sind, um beim Beschichten ein Durchströmen der Ausgießkanäle mit Beschichtungsgas und/oder Beschlichtungsplasma zu ermöglichen.

Vorteilhafte Ausgestaltungen der Erfindung sind in den Unteransprüchen angegeben. In den Rahmen der Erfindung fallen sämtliche Kombinationen aus zumindest zwei von in der Beschreibung, den Ansprüchen und/oder den Figuren offenbarten Merkmalen.

Zur Vermeidung von Wiederholungen sollen vorrichtungsgemäß offenbarte Merkmale auch als verfahrensgemäß offenbart gelten und beanspruchbar sein. Ebenso sollen verfahrensgemäß offenbarte Merkmale auch als vorrichtungsgemäß offenbart gelten und beanspruchbar sein.

Der Erfindung liegt der Gedanke zugrunde, eine Mehrzahl von Kunststoffausgießern derart auf einem Träger zu positionieren, dass die Kunststoffausgießer während der Beschichtung mit ihrer jeweiligen, insbesondere seitlich bzw. mantelseitig am Fixierabschnitt vorgesehenen Siegelfläche dem Träger zur Maskierung gegen eine Beschichtung mit der Barriereschicht zugewandt sind. Anders ausgedrückt hat der Träger der erfindungsgemäßen Vorrichtung und des erfindungsgemäßen Verfahrens nicht nur die Aufgabe des Tragens der Kunststoffausgießer bzw. der Relativpositionierung der Kunststoffausgießer zueinander während der Beschichtung sondern dient gleichzeitig als Maske zum Schutz der Siegelfläche vor einer Beschichtung. Hierzu muss der Träger so auf den Kunststoffausgießer abgestimmt sein, dass dieser die Siegelfläche verdeckt, wobei ein etwaiger Restspalt zwischen Kunststoffausgießer und Träger so eng bemessen ist, dass das Beschichtungsgas und/oder -plasma bei den üblichen, zur Anwendung kommenden Beschichtungsverfahren im Vakuum, insbesondere einem ALD-Verfahren (Atomic layer deposition-Verfahren), einem CVD-Verfahren (Chemical vapour deposition-Verfahren) oder einem PVD-Verfahren (Physical vapour deposition-Verfahren) nicht oder nur unzureichend eindringt, um somit eine Beschichtung der Siegelfläche mit der Barriereschicht zumindest weitgehend zu vermeiden. Hierzu umschließt der Träger die, vorzugsweise vollumfänglich um den Fixierabschnitt umlaufende, und, bevorzugt winklig, insbesondere senkrecht, zu einer Aufsetzrichtung der Spouts auf dem Träger orientierte, Siegelfläche bevorzugt vollumfänglich, was beispielsweise dadurch erzielt werden kann, dass die Kunststoffausgießer mit ihrem jeweiligen Fixierabschnitt, zumindest abschnittsweise, vorzugsweise vollständig in einer jeweiligen Vertiefung des (gemeinsamen) Trägers aufgenommen werden, wobei dann die Innenumfangwand (Vertiefungswand) der jeweiligen Vertiefung als Maske zum Schutz gegen eine Beschichtung dient. Für das erfindungsgemäße Verfahren ist es nicht notwendig eine spezielle, insbesondere rauere Siegelfläche vorzusehen. Auch wird mit Vorteil erreicht, dass auf von dem Träger separate, d.h. separat relativ zu den Kunststoffausgießern zu positionierende Masken, wie diese zur Maskierung von Siegelzonen an Bechern bekannt sind, zur Maskierung der Siegelflächen der Spouts verzichtet werden kann - derartige, eher flächige Masken wären für den erfindungsgemäßen Zweck der Maskierung einer mantelseitigen Siegelfläche von Spouts ohnehin nicht geeignet, das diese diese seitliche und sich entlang der Längserstreckung des Ausgießkanals erstreckende, im Wesentlichen also senkrecht orientierte Siegelfläche des Fixierabschnitts von Kunststoffausgießern nicht vor einer Beschichtung schützen würden. Durch den Verzicht auf von dem Träger separate Masken kann auf eine separate Maskenauflage- und einen Maskenabnahmeschritt verzichtet werden.

Insgesamt wird somit ein einfaches und effektives Verfahren sowie eine einfache und effektive Vorrichtung zum Beschichten von Kunststoffausgießern (Spouts) angegeben, mit dem sich ohne spezielle Vorbereitung der Kunststoffausgießer und ohne den Einsatz zusätzlich zum Träger vorgesehener Masken eine Beschichtung der Siegelfläche mit der vorzugsweise SiOₓ umfassenden oder aus SiOₓ bestehenden Vakuum-Barriereschicht sicher verhindert werden kann.

Im Rahmen der vorliegenden Offenbarung wird im Folgenden des öfteren von "oben" und "unten" gesprochen - diese Positionen beziehen sich auf die Axialerstreckung des Ausgießkanals, wobei sich ein Einlass des Ausgießkanals "unten", d.h. im Bereich einer dem Packgut zugewandten Innenseite des Ausgießers befindet und "oben" im Bereich einer Auslassöffnung des Ausgießkanals, die sich vorzugsweise an einem über den Fixierabschnitt vorstehenden Rohr befindet, welches noch weiter bevorzugt einteilig (monolithisch) mit dem Fixierabschnitt ausgebildet ist. Bevorzugt sind bei einer fertigen Verpackung dem Auslassende bzw. der Auslassöffnung Verschlussmittel zugeordnet, beispielsweise in Form eines Drehverschlusses der noch weiter bevorzugt auf ein vorzugsweise am Außenumfang des Rohrabschnittes vorgesehenes Außengewinde aufschraubbar ist. Unabhängig davon ist es bevorzugt, wenn ein Verhältnis zwischen einem Ausgießkanaldurchmesser und einer Ausgießkanallängenerstreckung maximal 1 : 1 vorzugsweise 1 : 2 oder kleiner ist.

Wie erwähnt befindet sich die Siegelfläche bevorzugt seitlich am Fixierabschnitt, der gegenüber dem Ausgießkanal und/oder einem bevorzugt den Ausgießkanal zumindest abschnittsweise bildenden Rohrabschnitt in radialer Richtung bezogen auf die Axialerstreckung des Ausgießkanals bzw. des Rohrabschnitts verdickt ausgebildet ist. Bevorzugt hat der Fixierabschnitt eine schiffchenförmige Kontur, ist also von zwei konvexen Halbschalenabschnitten gebildet, die sich bevorzugt jeweils in der Art einer Glockenkurve an einer eine Aufsetzrichtung zum Aufsetzen des Spouts auf dem Träger aufnehmenden Symmetrieebene treffen, so dass der Fixierabschnitt in der Art eines Schiffchens an zwei entlang einer sich senkrecht zur Axialerstreckung des Ausgießkanals erstreckenden Achse einander gegenüberliegenden Enden spitz zuläuft und in einem mittleren Bereich an einander gegenüberliegenden Seiten bauchig ausgeformt ist. Die Siegelfläche befindet sich mantelseitig an dem Fixierabschnitt und umschließt diesen vollumfänglich und erstreckt sich dabei im Wesentlichen parallel zur Axialerstreckung des Ausgießkanals bzw. des vorerwähnten Rohrabschnitts. Insbesondere bei einer derartigen Ausgestaltung des Fixierabschnitts, jedoch auch unabhängig davon, ist es bei einer sich im Wesentlichen senkrecht zur einer Innenseite erstreckenden, d.h. mantelseitigen Siegelfläche von Vorteil den Kunststoffausgießer zur Maskierung der Siegelfläche mit seinem Fixierabschnitt zumindest abschnittsweise, vorzugsweise vollständig in einer jeweiligen Trägervertiefung zu versenken. Die vorerwähnte Innenseite des Kunststoffausgießers bildet eine, bevorzugt in der vorerwähnten Aufsetzrichtung vordere, insbesondere untere, Grundseite, die zum Packgut weist bzw. unmittelbar vom Packgut bei einer den Kunststoffausgießer umfassenden Verpackung, insbesondere Standbeutelverpackung Kontakt hat. Diese Innenseite erstreckt sich bevorzugt senkrecht zur Längserstreckung bzw. Axialerstreckung des Ausgießkanals. Die Innenumfangswände der Vorrichtung, d.h. die Vertiefungswände umgebend die Siegelfläche bevorzugt vollumfänglich, insbesondere mit geringem Radialabstand und schützen somit die Siegelfläche vor einer Beschichtung mit der Vakuum-Barriereschicht. Besonders bevorzugt ist es, wenn die Vertiefungen jeweils mit Einlaufschrägen versehen sind, um ein erleichtertes Finden der Vertiefungen bei einem automatisierten, gleichzeitigen Einsetzen einer Mehrzahl von Kunststoffausgießern vor dem eigentlichen Beschichtungsprozess zu ermöglichen.

Besonders zweckmäßig ist es, wenn das vorerwähnte Spaltmaß, d.h. ein Radialspalt zwischen der, insbesondere mantelseitigen Siegelfläche und den Vertiefungswänden so gewählt ist, dass dieser auf der einen Seite zwar übliche Fertigungstoleranzen bzw. Temperaturtoleranzen, d.h. Maßtoleranzen von Kunststoffausgießern berücksichtigt, auf der anderen Seite jedoch so eng bemessen ist, dass Beschichtungsgas und/oder - plasma nicht oder nicht ausreichend eindringt, um die Siegelfläche vollständig zu beschichten. Zusätzlich oder alternativ zur Realisierung eines solchen Spaltmaßes können, wie später noch erwähnt werden wird, zusätzliche Dichtmaßnahmen zur Abdichtung eines solchen Radialspaltes vorgesehen werden, beispielsweise in dem sich der Kunststoffausgießer über einen oberhalb der Siegelfläche, d.h. mit Abstand zur Innenseite angeordneten radialen Ringabsatz am Träger abstützt, insbesondere auf diesem aufliegt und/oder mittels eines unteren, axial vorstehenden Ringabsatzes auf dem Träger, insbesondere an einem Vertiefungsgrund aufsteht.

Im Hinblick auf bevorzugte Spaltmaße wird auf die Angaben in den Ansprüchen verwiesen. Bevorzugt handelt es sich bei den Abmessungen um ein mittleres oder maximales Radialspaltmaß. Unabhängig davon ist es bevorzugt, wenn der Kunststoffausgießer über mindestens 50 %, bevorzugt mindestens 80 %, ganz besonders bevorzugt 100 % seiner (sich in Richtung der Längs- bzw. Axialerstreckung des Ausgießkanals erstreckenden) Höhenerstreckung ihrer Fixierabschnitte in den Vertiefungen versenkt werden, damit ein möglichst großer Anteil der Mantelfläche der Fixierabschnitte als besiegelbare Siegelfläche zur Verfügung steht.

Wie bereits angedeutet ist es vorteilhaft einen etwaigen Radialspalt zwischen einer Vertiefungswandung und Siegelfläche durch weitere Maßnahmen besser abzudichten. Eine Möglichkeit hierzu besteht darin am Fixierabschnitt, mit Axialabstand zur Innenseite, insbesondere oberhalb der Siegelfläche einen bevorzugt vollständig umlaufenden, Ringabsatz, insbesondere in Form eines Ringwulstes oder eines Ringkragens vorzusehen, mit dem sich der Kunststoffausgießer, insbesondere axial und/oder radial bezogen auf die Axialerstreckung des Ausgießkanals am Träger, insbesondere an einem (oberen) Öffnungsrand oder einer Ringschulter der Vertiefung abstützt. Ganz besonders bevorzugt ist es, wenn sich der Kunststoffausgießer mit diesem Ringabsatz axial abstützt, so dass der Fixierabschnitt quasi an dem sich abstützenden Ringabsatz hängt. Zusätzlich oder alternativ kann sich der Ringabsatz in radialer Richtung, insbesondere am Innenumfang der Vertiefungswand abstützen.

Zusätzlich oder alternativ zu einer Abdichtung des Radialspaltes in einem oberen Bereich ist es möglich, entsprechende Abdichtmaßnahmen durch das Vorsehen eines entsprechenden Ringabsatzes in einem unteren, d.h. näher an der Innenseite gelegenen Fixierabschnitt zu realisieren, wobei der Ringabsatz bevorzugt auf der Innenseite (Unterseite) des Fixierabschnitts angeordnet ist und in axialer Richtung nach unten vorsteht. Zusätzlich oder alternativ kann der Ringabsatz in radialer Richtung vorstehen. Bevorzugt steht der Kunststoffausgießer in axialer Richtung mittels dieses Ringabsatzes auf dem Träger auf, so dass ein Gaseintritt von unten in dem vorerwähnten Radialspalt zwischen Fixierabschnitt bzw. Siegelfläche und Innenumfangswand der Vertiefungswand erschwert wird. Bevorzugt steht der Kunststoffausgießer mit dem Ringabsatz auf einem vorzugsweise von einem Ringabsatz gegründeten Vertiefungsgrund des Kunststoffausgießers auf, wobei dieser Ringabsatz bevorzugt einen erfindungsgemäß vorgesehenen, später noch zu erläuternden Durchbruch im Träger umgibt.

Erfindungsgemäß ist vorgesehen, dass der Träger eine Mehrzahl von Durchbrüchen, insbesondere jeweils in einem unteren Bereich der vorerwähnten Vertiefungen aufweist. Diese axialen Durchbrüche sind ausgebildet und angeordnet, um beim Beschichten ein Durchströmen des Ausgießkanals mit Beschichtungsgas und/oder Beschichtungsplasma zu ermöglichen, was im Rahmen der Beschichtung auch erfolgt. Hierzu fluchten die Ausgießkanäle axial mit den Durchbrüchen. Bevorzugt ist die freie Querschnittsfläche der Durchbrüche größer als die Querschnittsfläche der Ausgießkanäle und entspricht bevorzugt mindestens 60 % der axialen Projektionsfläche des Fixierabschnitts bevorzugt auf die Axialerstreckung des Ausgießkanals, noch weiter bevorzugt mindestens 80 %, ganz besonders bevorzugt mindestens 90 %, um somit eine zumindest weitgehende Beschichtung einer Innenseite des Fixierabschnitts bzw. des Kunststoffausgießers zu ermöglichen zusätzlich zur Beschichtung des Ausgießkanals.

Um automatisiertes Positionieren der Kunststoffausgießer, insbesondere gleichzeitig in einer großen Anzahl, auf dem Träger und insbesondere in bevorzugt vorgesehenen, zuvor erwähnten Vertiefungen des Trägers zu ermöglichen, ist in Weiterbildung der Erfindung mit Vorteil vorgesehen, dass den Kunststoffausgießern zur Zentrierung derselben relativ zu dem Träger, bevorzugt zu den Umfangswänden der Vertiefungen, vorzugsweise die vorerwähnten Durchbrüche des Trägers an einer Vorrichtungsstation durchsetzende, Zentrierdorne zugeordnet sind. Diese befinden sich, wie angedeutet bevorzugt an einer Zentrier- oder Aufsetzstation, an die der Träger zum Aufsetzen der Kunststoffausgießer transportiert wird. Der Träger läuft bevorzugt im Rahmen des Beschichtungsverfahrens zwischen verschiedenen Stationen um und wird nach dem Aufsetzen der Kunststoffausgießer in die Beschichtungskammer gefördert. Bevorzugt ist die Aufsetzstation dabei derart ausgebildet, dass an dieser die Durchbrüche von unten durchfahren werden von den Zentrierdornen, auf die dann von der gegenüberliegenden Seite, d.h. bevorzugt von oben die Kunststoffausgießer aufgesetzt werden. Bevorzugt erfolgt die Zentrierung derart, dass ein allseitig gleicher Radialabstand zwischen Siegelfläche und Träger bzw. Siegelfläche und Vertiefungsinnenwand resultiert.

Die Kunststoffausgießer werden bevorzugt mit ihren Ausgießkanälen auf die Zentrierdorne ausgesetzt, wobei Greifer zum Einsatz kommen - hierbei kann es sich beispielsweise um Vakuumgreifer und/oder Klemmgreifer handeln, die die Kunststoffausgießer durch Unterdruckbeaufschlagung und/oder mechanisch durch Klemmen greifen - alternativ ausgebildete Greifer sind ebenfalls denkbar bzw. einsetzbar. Bevorzugt erfolgt jedenfalls das Aufsetzen der Kunststoffausgießer mit ihren Ausgießkanälen auf die Zentrierdorne derart, dass die Kunststoffausgießer nach dem Aufsetzen entlang der Zentrierdorne in die jeweils zugehörige Vertiefung gleiten und dass die Zentrierdorne danach aus den Ausgießkanälen entfernt werden, bevorzugt durch Herausziehen nach unten durch die Durchbrüche im Träger hindurch.

Um gleichzeitig eine große Anzahl, vorzugsweise sämtliche Kunststoffausgießer eines Trägers auf dem Träger positionieren zu können ist es bevorzugt, wenn einzelne Greifer oder Gruppen von Greifern senkrecht zur Längserstreckung der Zentrierdorne relativ zueinander beweglich, insbesondere schwimmend gelagert sind, um somit einen Abstands- bzw. Radialausgleich der Kunststoffausgießer bzw. der Greifer bzw. Gruppen von Greifern beim Aufsetzen der Kunststoffausgießer auf die Dorne zu ermöglichen.

Ganz besonders bevorzugt ist es, wenn nicht nur die Kunststoffausgießer relativ zu den Zentrierdornen ausgerichtet werden, sondern insbesondere auch die die Kunststoffausgießer tragenden Greifer, insbesondere einzeln oder in Gruppen, bevorzugt durch das Vorsehen mechanischer Zentriermittel, insbesondere endseitige Einlaufkegel an den Zentrierdornen, die in entsprechende Aufnahmen der Greifer oder Gruppen von Greifer gleiten, bevor die Greifer die Kunststoffausgießer auf die Zentrierdorne entlassen bzw. dort ablegen bzw. ablassen.

Besonders zweckmäßig ist es, wenn im Rahmen des Verfahrens nach erfolgter Beschichtung und der Entnahme der Kunststoffausgießer aus dem Träger die Kunststoffausgießer an eine Verpackungsbehälterhülle, insbesondere eine Standbeutelfolie gesiegelt werden, insbesondere thermisch durch Anschmelzen im Bereich der nicht vollflächig mit einer Barriereschicht beschichteten Siegelfläche.

Als besonders zweckmäßig hat es sich herausgestellt, wenn das Beschichten der Kunststoffausgießer inline mit der Herstellung der Kunststoffausgießer erfolgt, die bevorzugt in einem vorgelagerten Kunststoffspritzgussverfahren hergestellt werden derart, dass die Kunststoffausgießer zur Realisierung schneller Taktzeiten im noch von dem Herstellungsprozess über Raumtemperatur von 22°C erwärmten Zustand, d.h. bei einer Kunststoffgießertemperatur von über 22°C, vorzugsweise von über 50°C noch weiter bevorzugt von über 80°C auf den Träger aufgesetzt werden. Dabei ist zu berücksichtigen, dass die Kunststoffausgießer sich noch abkühlen und sich dadurch deren Abmessungen reduzieren, was bei der Spaltauslegung des Umfangsspaltes bzw. Radialspaltes zwischen der Siegelfläche und dem Träger zu berücksichtigen ist. Alternativ ist es denkbar, die Kunststoffausgießer zu einem späteren Zeitpunkt im abgekühlten Zustand mit der Barriereschicht zu beschichten.

Die Erfindung führt auch auf eine Vorrichtung zur Durchführung eines zuvor im Detail geschilderten Verfahrens. Die Vorrichtung weist entsprechende Mittel zur Durchführung der entsprechenden Verfahrensschritte auf. Dabei ist der, vorzugsweise Vertiefungen zur Aufnahme der Kunststoffausgießer aufweisende Träger Bestandteil der Vorrichtung, wobei der Träger verschiedene Stationen der Vorrichtung durchläuft, insbesondere eine Aufsetzstation, an der die Kunststoffausgießer mit entsprechenden Handhabungsmitteln auf den Trägern, insbesondere in Vertiefungen auf- bzw. abgesetzt werden, insbesondere durch das Vorsehen entsprechender, zuvor im Detail erläuterter Zentrierdorne.

Weitere Vorteile, Merkmale und Einzelheiten der Erfindung ergeben sich aus der nachfolgenden Beschreibung bevorzugter Ausführungsbeispiele sowie anhand der Zeichnungen.

Diese zeigen in:
- Fig. 1:: eine ausschnittsweise Darstellung eines Trägers (Werkstückträger) zur Aufnahme einer Mehrzahl von Kunststoffausgießern (Spouts) für einen Beschichtungsprozess in einer Draufsicht von oben,
- Fig. 2:: eine teilgeschnittene Seitenansicht des Trägers gemäß Fig. 1 mit darin aufgenommenem Spout sowie in dem Spout angeordneten Zentrierstempel zur Positionierung des Spouts relativ zu einer Vertiefungswand einer Vertiefung des Trägers,
- Fig. 3:: eine perspektivische Darstellung des Trägers gemäß Fig. 1 mit einem beispielhaft in einer Vertiefung aufgenommenen Kunststoffausgießer,
- Fig. 4:: eine Darstellung des Trägers ohne Kunststoffausgießer, jedoch mit aus Übersichtlichkeitsgründen nur einem Zentrierdorn,
- Fig. 5:: eine Detaildarstellung des Zentrierdorns gemäß Fig. 5,
- Fig. 6a bis 6d:: unterschiedliche Ansichten eines beispielhaft zu beschichtenden Kunststoffausgießers,
- Fig. 7:: eine Darstellung eines Trägers mit exemplarisch einem in einer Vertiefung aufgenommenen Spout in einer Ansicht von oben,
- Fig. 8:: eine teilweise geschnittene Seitenansicht der Darstellung gemäß Fig. 7,
- Fig. 9:: eine Detailvergrößerung des in der Vertiefung aufgenommenen Kunststoffausgießers gemäß Fig. 8, aus dem ersichtlich ist, dass zur Abdichtung eines Radialspaltes zwischen dem Kunststoffausgießer, genauer dessen Siegelfläche und der Vertiefungswand sich der Kunststoffausgießer am Träger, genauer am oberen Vertiefungsrand mit einem als Ringkragen ausgebildeten Ringabsatz abstützt, und
- Fig. 10:: eine alternative Ausgestaltung des Details gemäß Fig. 8, bei dem der vorerwähnte Radialspalt durch einen axial vorstehenden unteren Ringabsatz in Form eines Ringwulstes abgedichtet wird, mit dem der Kunststoffausgießer im Bereich eines Vertiefungsgrundes auf dem Träger aufsteht.

In den Figuren sind gleiche Elemente und Elemente mit der gleichen Funktion mit den gleichen Bezugszeichen gekennzeichnet.

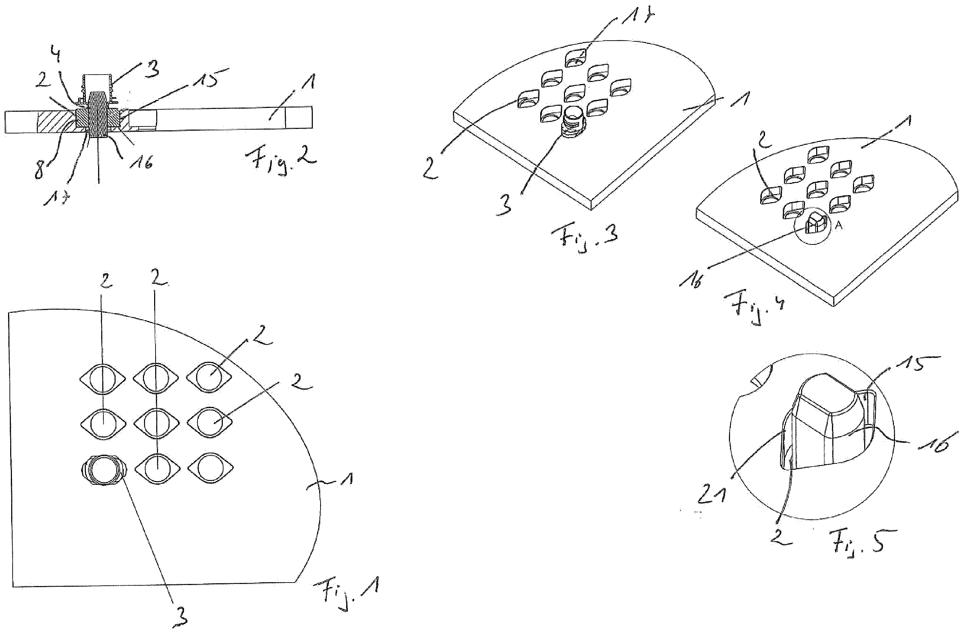

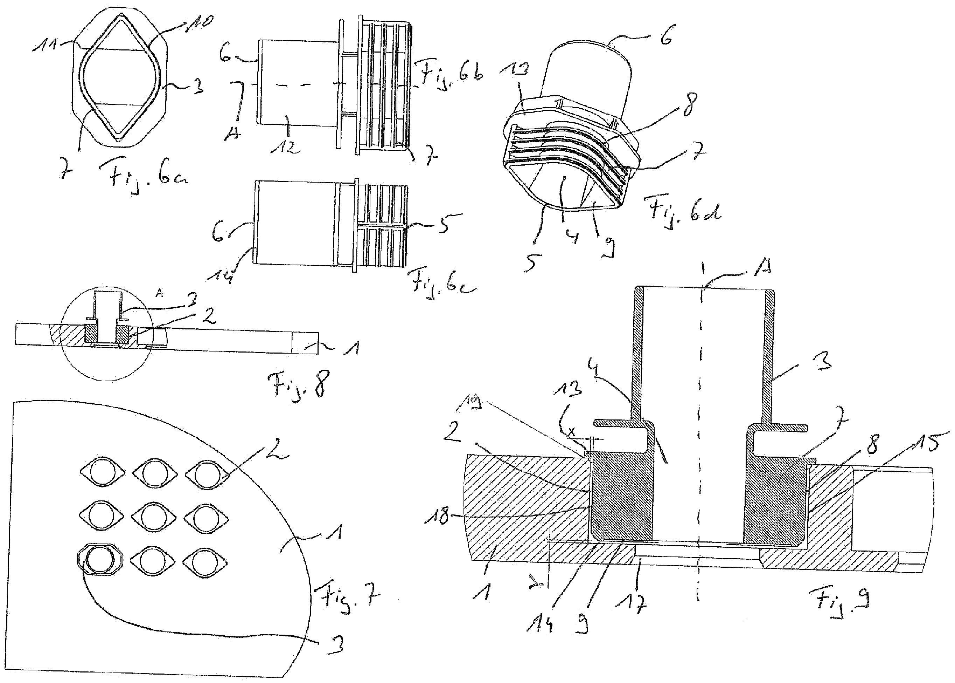

In den Fig. 1 bis 5 ist ein Träger 1 (Werkstückträger) einer erfindungsgemäßen Vorrichtung bzw. zur Durchführung eines erfindungsgemäßen Verfahrens gezeigt, teilweise mit und teilweise ohne Kunststoffausgießer. Der Träger 1 umfasst eine Vielzahl von Vertiefungen 2 zur jeweiligen Aufnahme eines einzelnen Kunststoffausgießers 3 (Spout), dessen exemplarischer Aufbau später beispielhaft an den Darstellungen gemäß den Fig. 6a bis 6d erläutert werden wird - geometrische Abwandlungen hiervon sind selbstverständlich möglich.

Ein Kunststoffausgießer 3 umfasst generell einen Ausgießkanal 4, welcher die Verbindung zwischen einer Verpackungsinnenseite und einer Außenseite herstellt, wobei Packgut, insbesondere eine Flüssigkeit durch den Ausgießkanal 4 von innen nach außen strömen kann. Hierzu umfasst der Ausgießkanal 4 eine (untere) Einlassöffnung 5 und eine (obere) Auslassöffnung 6. Der Ausgießkanal 4 durchsetzt axial einen bezogen auf den Ausgießkanal 4 verbreiterten Fixierabschnitt 7, welcher hier beispielhaft von_entlang der Achse A übereinander angeordneten Rippen gebildet ist - alternativ kann der Fixierabschnitt am Außenumfang vollflächig ausgestaltet sein. Ebenfalls bietet der Fixierabschnitt 7 an seinem Außenumfang, in dem konkreten Ausführungsbeispiel lediglich beispielhaft am Außenumfang der Rippen eine Siegelfläche 8 an zum späteren Ansiegeln eines Verpackungsmaterials, insbesondere einer Folie, weiter bevorzugt einer Standbeutelfolie. Ziel ist es, eine Beschichtung dieser Siegelfläche 8 mit der Vakuum-Barriereschicht, insbesondere einer SiOₓ-Schicht zu verhindern, während es weiteres Ziel ist, den Ausgießkanal 4 an seinem Innenumfang zu beschichten. Bevorzugt wird zusätzlich zumindest größtenteils eine Innenseite 9 (Unterseite) des Kunststoffausgießers 3 mit der Barriereschicht versehen.

Aus den Fig. 6a bis 6d ist zu erkennen, dass der Fixierabschnitt 7 im wesentlichen schiffchenförmig ausgestaltet ist, und, wie aus Fig. 6 zu erkennen ist, aus zwei konvex gewölbten Halbschalenabschnitten 10, 11 besteht, die in einem jeweiligen mittigen, einander gegenüberliegenden Bereich bauchig bzw. konvex gewölbt ausgestaltet sind und an beiden senkrecht orientierten Richtungen bzw. Endseiten in der Art eines Schiffchens spitz zulaufen.

Der Ausgießkanal 4 ist monolithisch mit dem Fixierabschnitt 7 ausgebildet und wird in dem konkreten Ausführungsbeispiel radial innen von diesem gebildet bzw. begrenzt - in dem den Fixierabschnitt 7 axial nach oben überragenden Abschnitt wird der Ausgießkanal 4 von einem Rohr 12 begrenzt, welches ebenfalls monolithisch mit dem Fixierabschnitt 7 ausgebildet ist. Bevorzugt trägt dieses Rohr 12 an seinem Außenumfang ein Außengewinde, welches aus Übersichtlichkeitsgründen nicht gezeigt ist, um hieran einen nicht gezeigten Verschlussdeckel festzulegen, um die Auslassöffnung 6 verschließen zu können.

Entlang der Axialerstreckung des Ausgießkanals, d. h. entlang der Achse A oberhalb der Siegelfläche 7 befindet sich ein umlaufender, als Ringkragen ausgebildeter oberer Ringabschnitt 13. Auf der Unterseite bzw. Innenseite des Fixierabschnitts 7 befindet sich ein axial vorstehender unterer, als Ringwulst ausgebildeter Ringabschnitt 14, wobei die Funktionen der Ringabschnitte 13, 14 später noch erläutert werden.

In den Fig. 1 bis 3 ist zu erkennen, dass die mantelseitige Siegelfläche 8 des Kunststoffausgießers 3 einer Vertiefungswand 15 einer Vertiefung 2 vollumfänglich gegenüberliegt, so dass die Siegelfläche 8 vor einer Beschichtung geschützt ist. Die Siegelfläche 8 befindet sich vollständig innerhalb der zugehörigen Vertiefung 2. Die Vertiefungen 2 sind, wie sich beispielsweise aus Fig. 5 ergibt mit oberen Einlaufschrägen 21 versehen, um ein erleichtertes automatisches Finden der Vertiefung durch die Spouts zu ermöglichen.

Aus Fig. 2 ist weiter zu entnehmen, dass sich in einem unteren Abschnitt des Ausgießkanals 4 temporär ein Zentrierdorn 16 befindet, der in Pfeilrichtung gemäß Fig. 2 nach unten durch einen Durchbruch 17 im Träger 1 nach der Zentrierung des Kunststoffausgießers 3 wieder herausgezogen werden kann. Bevorzugt erfolgt die Zentrierung an einer entsprechenden Aufsetzstation der Vorrichtung, die einer nicht gezeigten Beschichtungskammer vorgelagert ist. Der Durchbruch 17 ist bevorzugt so bemessen, dass ein Grossteil der axialen Projektionsfläche, d.h. der Unterseite des Fixierabschnitts bzw. von dessen Innenseite 9 mit dem Beschichtungsgas und/oder -plasma zur Beschichtung mit einer Barriereschicht in Kontakt kommt - dies bedeutet, dass eine noch größere Ausgestaltung als in den Figuren gezeigt möglich und bevorzugt ist.

In den Fig. 7 und 8 ist wiederum ein Träger 1 (in Fig. 8 teilweise geschnitten) dargestellt. Zu erkennen ist ein in einer Vertiefung 2 befindlicher exemplarischer Kunststoffausgießer 3, wobei diese Situation in Fig. 9 vergrößert dargestellt ist. Zu erkennen ist, dass der Kunststoffausgießer 3 mit seiner randseitigen bzw. sich senkrecht, d.h. parallel zur Axialerstreckung entlang der Achse A erstreckenden Siegelfläche 8 vollständig in der Vertiefung 2 aufgenommen ist, so dass die Siegelfläche 8 unter Einhaltung eines geringeren Radialabstandes x, von beispielsweise 0,2 mm der Vertiefungswand 15 gegenüberliegt. Aufgrund der Zentrierung ist der Radialabschnitt x allseitig zumindest näherungsweise gleich groß bemessen. Zu erkennen ist auch der untere Durchbruch 17, der eine zumindest teilweise Beschichtung der Innenseite 9 ermöglicht - wie bereits erwähnt könnte dieser Durchbruch 17 auch mit einer größeren als gezeigten freien Querschnittsfläche realisiert werden.

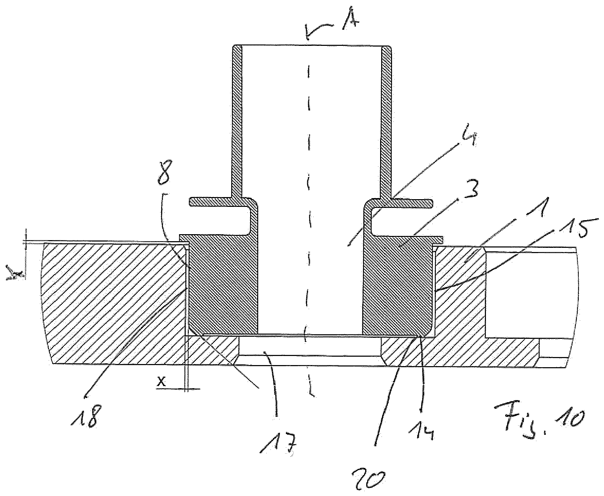

Wesentlich bei der Darstellung gemäß Fig. 9 ist, dass der Radialspalt 18 mit dem Spaltmaß x von oben her abgedichtet ist über einen bereits erwähnten, oberen Ringabsatz 13, mit dem der Kunststoffausgießer 3 auf dem Träger 1, randseitig bezogen auf die Vertiefung 2 aufliegt, so dass der Fixierabschnitt 7 quasi an den Ringabsatz hängend in der Vertiefung 2 aufgenommen ist. Zwischen einer Unterseite des Kunststoffausgießers 3 und dem Vertiefungsgrund ist ein Spaltmaß y realisiert, beispielsweise ebenfalls von 0,2 mm. Das Bezugszeichen 19 kennzeichnet die ringförmige bzw. umlaufende Auflageposition 19 des Ringabsatzes 13 des Kunststoffausgießers 3 auf dem Träger 1. Zusätzlich oder alternativ zu der in Fig. 9 gezeigten Position kann sich der Kunststoffausgießer 3 bei entsprechender Auslegung der Vertiefung 2 mit dem unteren Ringabsatz 14 am Träger 1 abstützen. Dies ist in Fig. 10 als alternative Ausführung zu der Ausführung in Fig. 9 gezeigt. Wie erwähnt ist es bei Einhaltung entsprechender Toleranzen denkbar, die Ausführungen gemäß den Fig. 9 und 10 zu kombinieren, dass also der Radialspalt 18 oben und unten über beide Ringabsätze 13, 14 abgedichtet ist.

Im Folgenden wird die Ausführung gemäß Fig. 10 erläutert. Diese unterscheidet sich von der Ausführungsvariante gemäß Fig. 9 dadurch, dass der Kunststoffausgießer 3 mit dem axial nach unten vorstehenden, umlaufenden, als Ringwulst ausgebildeten Ringabsatz 14 am Vertiefungsgrund 20, radial nach außen versetzt zum Durchbruch 17 aufsteht und somit eine Abdichtung des Radialspaltes 18 zwischen der Siegelfläche 8 und der Vertiefungswand 15 realisiert ist.

Für den bevorzugten Fall, dass sowohl ein oberer Ringabschnitt 13 als auch ein unterer Ringabschnitt 14 vorgesehen sind ist bei entsprechenden Toleranzbedingungen zumindest eine der Abdichtungen oben oder unten gegeben, d.h. entweder hängt der Fixierabschnitt 7 am oberen Ringabsatz 13 oder der Fixierabschnitt stützt sich axial unten am Träger 1 ab - im Idealfall sind, wie erwähnt, beide Dichtungen gegeben.

### Bezugszeichen

- 1: Träger
- 2: Vertiefungen
- 3: Kunststoffausgießer
- 4: Ausgießkanäle
- 5: Einlassöffnungen
- 6: Auslassöffnungen
- 7: Fixierabschnitte
- 8: Siegelflächen
- 9: Innenseiten
- 10: erste Halbschalen
- 11: zweite Halbschalen
- 12: Rohre
- 13: obere Ringabschnitte
- 14: untere Ringabschnitte
- 15: Vertiefungswände
- 16: Zentrierdorne
- 17: Durchbrüche
- 18: Radialspiele
- 19: Auflagepositionen
- 20: Vertiefungsgründe
- 21: Einlaufschrägen

- x: Radialspaltmaß
- y: Spaltmaß
- A: Achse / Axialerstreckung der Ausgießkanäle

## Patentansprüche

1. Verfahren zum Beschichten von, insbesondere durch Spritzgießen hergestellten, Kunststoffausgießern (3) (Spouts) für Packgut-Verpackungen, insbesondere für Standbeutelverpackungen, umfassend einen eine Siegelfläche (8) zum Festlegen einer Verpackungsbehälterhülle, insbesondere einer Standbeutelfolie, durch, bevorzugt thermisches, Siegeln aufweisenden Fixierabschnitt (7) und einen sich in einer Axialrichtung erstreckenden, den Fixierabschnitt (7) durchsetzenden, vorzugsweise den Fixierabschnitt (7) axial überragenden, Ausgießkanal (4), mit einer, insbesondere SiOₓ umfassenden, Barriereschicht im Vakuum zum Erhöhen der Durchtrittssperrwirkung gegen mindestens eine chemische Verbindung und/oder mindestens ein chemisches Element auf einer Innenoberfläche des Ausgießkanals (4), wobei gleichzeitig eine Mehrzahl von Kunststoffausgießern (3) in einer Vakuumbeschichtungskammer mit der Barriereschicht im Vakuum, vorzugsweise durch ein ALD-Verfahren, ein CVD-Verfahren oder ein PVD-Verfahren, beschichtet werden,
**dadurch gekennzeichnet,**
**dass** die Kunststoffausgießer (3) vor dem Beschichten mit der Barriereschicht derart auf einen Träger (1) aufgesetzt werden, dass die Kunststoffausgießer (3) während der Beschichtung mit ihrer jeweiligen Siegelfläche (8) dem Träger (1) zur Maskierung gegen eine Beschichtung mit der Barriereschicht zugewandt sind, und dass jedem Kunststoffausgießer (3) ein axialer Durchbruch (17) des Trägers (1), zugeordnet wird, derart dass die Ausgießkanäle (4) mit den Durchbrüchen (17) fluchten und somit während der Beschichtung im Vakuum Beschichtungsgas und/oder Beschichtungsplasma die Durchgangsöffnungen und Ausgießkanäle (4) durchströmt.

2. Verfahren nach Anspruch 1,
**dadurch gekennzeichnet,**
**dass** die Siegelflächen (8) der Kunststoffausgießer (3) von einer jeweiligen, sich winklig, insbesondere senkrecht, bevorzugt schiffchenförmig konturierten, Fixierabschnitts (7) gebildet werden und dass die Kunststoffausgießer (3) mit ihren Fixierabschnitten (7) in, vorzugsweise jeweils eine Einlaufschräge aufweisenden, Vertiefungen (2) des Trägers (1) aufgenommen werden und die Siegelflächen (8) einer jeweiligen Vertiefungswand (15), bevorzugt radial bezogen auf eine Axialerstreckung der Ausgießkanäle (4), gegenüberliegen.

3. Verfahren nach Anspruch 2,
**dadurch gekennzeichnet,**
**dass** ein, insbesondere radiales, bevorzugt mittleres, Spaltmaß (x) zwischen den Siegelflächen (8) und den Vertiefungswänden (15) zwischen 0,1mm und 1mm, vorzugsweise zwischen 0,1mm und 0,7mm, weiter bevorzugt zwischen 0,1mm und 0,5 mm, ganz besonders bevorzugt zwischen 0,15mm und 0,4mm, noch weiter bevorzugt zwischen 0,2mm und 0,3mm gewählt wird und/oder dass die Kunststoffausgießer (3) über mindestens 50%, bevorzugt mindestens 80%, ganz bevorzugt 100%, der Höhenerstreckung ihrer Fixierabschnitte (7) in den Vertiefungen (2) versenkt werden.

4. Verfahren nach einem der vorhergehenden Ansprüche,
**dadurch gekennzeichnet,**
**dass** die Kunststoffausgießer (3) jeweils an ihrem jeweiligen Fixierabschnitt (7) einen umlaufenden und in radialer Richtung vorstehenden Ringabsatz, insbesondere Ringwulst oder Ringkragen aufweisen, mit dem sich die Kunststoffausgießer (3), insbesondere axial und/oder radial bezogen auf die Axialerstreckung des jeweiligen Ausgießkanals (4), zur Abdichtung eines axial benachbart zum Ringkragen, insbesondere unterhalb des Ringkragens, gebildeten Spaltes zwischen der Siegelfläche (8) und dem Träger (1) am Träger (1), insbesondere an einem Öffnungsrand der Vertiefung, abstützen.

5. Verfahren nach einem der vorhergehenden Ansprüche,
**dadurch gekennzeichnet,**
**dass** die Kunststoffausgießer (3) an ihrem Fixierabschnitt (7) einen umlaufenden und in axialer Richtung nach unten und/oder radial vorstehenden Ringabsatz, insbesondere Ringwulst oder Ringkragen aufweisen, mit dem sich die Kunststoffausgießer (3), insbesondere axial und/oder radial bezogen auf die Axialerstreckung des Ausgießkanals (4), zur Abdichtung eines unterhalb des Ringkragens gebildeten Spaltes zwischen der Siegelfläche (8) und dem Träger (1) am Träger (1), insbesondere an einem Vertiefungsgrund (20), abstützen.

6. Verfahren nach einem der vorhergehenden Ansprüche,
**dadurch gekennzeichnet,**
**dass** die Durchbrüche (17) so relativ zu den Kunststoffausgießern (3) bemessen sind, dass die freie Querschnittsfläche jedes Durchbruchs (17) mindestens 60%, bevorzugt mindestens 80%, noch weiter bevorzugt mindestens 90% der axialen Projektionsfläche des Fixierabschnitts (7) des zugehörigen Kunststoffausgießers (3) entspricht.

7. Verfahren nach einem der vorhergehenden Ansprüche,
**dadurch gekennzeichnet,**
**dass** den Kunststoffausgießern (3) zur Zentrierung derselben relativ zu dem Träger (1), bevorzugt relativ zu den Umfangswänden der Vertiefungen (2), vorzugsweise die Durchbrüche (17) des Trägers (1) durchsetzende, Zentrierdorne (16) zugeordnet werden, bevorzugt an einer Aufsetzstation, an die der Träger (1) zum Aufsetzen der Kunststoffausgießer (3) transportiert wird und von der aus der Träger (1) nach dem Aufsetzen der Kunststoffausgießer (3) in die Beschichtungskammer gefördert wird.

8. Verfahren nach Anspruch 7,
**dadurch gekennzeichnet,**
**dass** die Kunststoffausgießer (3) mit ihren Ausgießkanälen (4) mittels Greifern, insbesondere Vakuumgreifern und/oder Klemmgreifern, auf die Zentrierdorne (16) aufgesetzt werden, bevorzugt derart, dass die Kunststoffausgießer (3) nach dem Aufsetzen entlang der Zentrierdorne (16) in die zugehörigen Vertiefungen (2) gleiten und dass die Zentrierdorne (16) danach aus den Ausgießkanälen (4) entfernt werden, bevorzugt durch die Durchbrüche (17) im Träger (1) hindurch.

9. Verfahren nach einem der Ansprüche 7 oder 8,
**dadurch gekennzeichnet,**
**dass** einzelne Greifer oder Gruppen von Greifen senkrecht zu Längserstreckung der Zentrierdorne (16) relativ zueinander beweglich, insbesondere schwimmend gelagert sind, um gleichzeitig die mehreren Greifer oder Gruppen von Greifen zusammen mit den Kunststoffausgießern (3) relativ zu den Zentrierdornen (16) auszurichten.

10. Verfahren nach einem der Ansprüche 7 bis 9,
**dadurch gekennzeichnet,**
**dass** die die Kunststoffausgießer (3) tragenden Greifer zunächst mithilfe mechanischer Zentriermittel, insbesondere mittels endseitige Einlaufkegel der Zentrierdorne (16) relativ zu den Dornen positioniert werden, bevor die Greifer die Kunststoffausgießer (3) ablassen.

11. Verfahren nach einem der vorhergehenden Ansprüche,
**dadurch gekennzeichnet,**
**dass** die Kunststoffausgießer (3) nach dem Beschichten an einer Verpackungsbehälterhülle, insbesondere einer Standbeutelfolie, durch, insbesondere thermisches, Siegeln der Verpackungsbehälterhülle an die Siegelfläche (8) flüssigkeitsdicht fixiert werden.

12. Verfahren nach einen der vorhergehenden Ansprüche,
**dadurch gekennzeichnet,**
**dass** das Beschichten der Kunststoffausgießer (3) inline mit der Herstellung der Kunststoffausgießer (3), insbesondere im Kunststoffspritzgussverfahren, erfolgt und dass die Kunsstoffausgießer (3) im noch von der Herstellung über Raumtemperatur erwärmten Zustand, vorzugsweise bei über 50°C, weiter bevorzugt bei über 80°C auf den Träger (1) aufgesetzt werden.

13. Vorrichtung zur Durchführung eines Beschichtungsverfahrens nach einem der vorhergehenden Ansprüche, umfassend eine Vakuumbeschichtungskammer zum gleichzeitigen Beschichten einer Vielzahl von Kunststoffausgießern (3) mit einer jeweiligen Barriereschicht im Vakuum sowie Handhabungsmittel zum Aufsetzen jeweils mehrerer Kunststoffausgießer (3) auf einen, vorzugsweise auf der Vorrichtung zwischen verschiedenen Stationen umlaufenden, Träger (1),
**dadurch gekennzeichnet,**
**dass** die Handhabungsmittel derart ausgebildet sind, dass diese die Kunststoffausgießer (3) derart auf den Träger (1) aufsetzen, dass die Kunststoffausgießer (3) während der Beschichtung mit ihrer Siegelfläche (8) dem Träger (1) zur Maskierung gegen eine Beschichtung mit der Barriereschicht zugewandt sind, und dass der Träger (1) eine Mehrzahl von Durchbrüchen (17) aufweist, die derart ausgebildet und angeordnet sind, um beim Beschichten ein Durchströmen der Ausgießkanäle (4) mit Beschichtungsgas und/oder Beschichtungsplasma zu ermöglichen.

14. Vorrichtung nach Anspruch 13,
**dadurch gekennzeichnet,**
**dass** der Träger (1) eine Vielzahl von Vertiefungen (2) zur jeweiligen Aufnahme eines der zu beschichtenden Kunststoffausgießer (3) aufweist.

## Claims

1. A method for coating plastic spouts (3), in particular produced by injection molding, for packaged-good packages, in particular for stand-up pouches, comprising a fixing portion (7) having a sealing surface (8) for fixing a packaging container jacket, in particular a stand-up pouch film, by preferably thermal sealing, and a spout channel (4) extending in an axial direction, penetrating the fixing portion (7) and preferably axially protruding beyond the fixing portion (7), with a barrier layer, in particular comprising SiOₓ, under vacuum in order to increase the permeation blocking effect against at least one chemical compound and/or at least one chemical element on an inner surface of the spout channel (4), a plurality of plastic spouts (3) being simultaneously coated with the barrier layer under vacuum in a vacuum coating chamber, preferably by an ALD method, a CVD method or a PVD method,
**characterized in that**
prior to being coated with the barrier layer, the plastic spouts (3) are placed on a support (1) in such a manner that the sealing surface (8) of each plastic spout (3) faces toward the support (1) during the coating process so as to be masked against being coated with the barrier layer, and that an axial through-hole (17) of the support (1) is assigned to each plastic spout (3) in such a manner that the spout channels (4) are aligned with the through-holes (17), coating gas and/or coating plasma thus flowing through the passage openings and spout channels (4) during the coating process under vacuum.

2. The method according to claim 1,
**characterized in that**
the sealing surfaces (8) of the plastic spouts (3) are formed by a respective fixing portion (7) which has an angular, in particular perpendicular, preferably boat-shaped contour and that the fixing portions (7) of the plastic spouts (3) are received in recesses (2) of the support (1), the recesses preferably having an entry slope, and the sealing surfaces (8) are disposed opposite, preferably radially in relation to an axial extension of the spout channels (4), to a respective recess wall (15).

3. The method according to claim 2,
**characterized in that**
an in particular radial, preferably mean, gap size (x) of between 0.1 mm and 1 mm, preferably between 0.1 mm and 0.7 mm, further preferably between 0.1 mm and 0.5 mm, particularly preferably between 0.15 mm and 0.4 mm, even further preferably between 0.2 mm and 0.3 mm, is selected between the sealing surfaces (8) and the recess walls (15) and/or that the plastic spouts (3) are inserted into the recesses (2) by at least 50 %, preferably at least 80 %, particularly preferably 100 % of the vertical extension of their fixing portions (7).

4. The method according to any one of the preceding claims,
**characterized in that**
the plastic spouts (3), at their respective fixing portion (7), each have a circumferential ring shoulder protruding in the radial direction, in particular a ring bulge or ring collar, by means of which the plastic spouts (3) are supported on the support (1), in particular on an opening edge of the recess, in particular axially and/or radially in relation to the axial extension of the respective spout channel (4) in order to seal a gap formed axially adjacent to the ring collar, in particular below the ring collar, between the sealing surface (8) and the support (1).

5. The method according to any one of the preceding claims,
**characterized in that**
the plastic spouts (3), at their fixing portion (7), have a circumferential ring shoulder protruding downward in the axial direction and/or radially, in particular a ring bulge or ring collar, by means of which the plastic spouts (3) are supported on the support (1), in particular on a recess bottom (20), in particular axially and/or radially in relation to the axial extension of the spout channel (4) in order to seal a gap formed below the ring collar between the sealing surface (8) and the support (1).

6. The method according to any one of the preceding claims,
**characterized in that**
in relation to the plastic spouts (3), the through-holes (17) are dimensioned in such a manner that the free cross-sectional area of each through-hole (17) corresponds to at least 60 %, preferably at least 80 %, further preferably at least 90 % of the axial projection area of the fixing portion (7) of the associated plastic spout (3).

7. The method according to any one of the preceding claims,
**characterized in that**
centering pins (16), preferably penetrating the through-holes (17) of the support (1), are assigned to the plastic spouts (3) for centering them relative to the support (1), preferably relative to the circumferential walls of the recesses (2), preferably at a placement station to which the support (1) is transported for placement of the plastic spouts (3) and from which the support (1) is conveyed into the coating chamber after the plastic spouts (3) have been placed thereon.

8. The method according to claim 7,
**characterized in that**
the plastic spouts (3) are placed on the centering pins (16) with their spout channels (4) by means of grippers, in particular vacuum grippers and/or clamping grippers, preferably in such a manner that the plastic spouts (3), once placed, slide along the centering pins (16) into the associated recesses (2) and that the centering pins (16) are subsequently removed from the spout channels (4), preferably through the through-holes (17) in the support (1).

9. The method according to any one of claims 7 or 8,
**characterized in that**
individual grippers or groups of grippers are mounted, in particular floating, in a manner moveable relative to each other perpendicular to the longitudinal extension of the centering pins (16) so that the multiple grippers or groups of grippers can be simultaneously oriented relative to the centering pins (16) in conjunction with the plastic spouts (3).

10. The method according to any one of claims 7 to 9,
**characterized in that**
the grippers carrying the plastic spouts (3) are first positioned relative to the pins with the aid of mechanical centering means, in particular by means of end-side entry cones of the centering pins (16), before the grippers lower the plastic spouts (3).

11. The method according to any one of the preceding claims,
**characterized in that**
after being coated, the plastic spouts (3) are fixed in a liquid-tight manner to a packaging container jacket, in particular to a stand-up pouch film by, in particular thermally, sealing the packaging container jacket to the sealing surface (8).

12. The method according to any one of the preceding claims,
**characterized in that**
the plastic spouts (3) are coated in line with the production of the plastic spouts (3), in particular by injection molding, and that the plastic spouts (3) are placed on the support (1) while they are still heated above room temperature from production, preferably at more than 50 °C, further preferably at more than 80 °C.

13. A device for carrying out a coating method according to any one of the preceding claims, comprising a vacuum coating chamber for simultaneously coating a plurality of plastic spouts (3) with a respective barrier layer under vacuum and handling means for placing multiple plastic spouts (3) at once onto a support (1), which preferably circulates on the device between different stations,
**characterized in that**
the handling means are configured in such a manner that they place the plastic spouts (3) on the support (1) in such a manner that the sealing surfaces (8) of the plastic spouts (3) face toward the support (1) during the coating process so as to be masked against being coated with the barrier layer, and that the support (1) has a plurality of through-holes (17) which are configured and disposed in such a manner that coating gas and/or coating plasma is allowed to flow through the spout channels (4) during the coating process.

14. The device according to claim 13,
**characterized in that**
the support (1) has a plurality of recesses (2) that serve to each receive one of the plastic spouts (3) to be coated.

## Revendications

1. Procédé pour revêtir des becs verseurs (3) en plastique, produits notamment par moulage par injection, pour des emballages de produits à emballer, notamment des emballages sous forme de sachets stand up, comprenant une partie de fixation (7) ayant une surface de scellage (8) pour la fixation d'une gaine de récipient d'emballage, notamment un film de sachet stand up, par scellage préférablement thermique, et un canal verseur (4) s'étendant dans une direction axiale, pénétrant la partie de fixation (7) et, de préférence, s'étendant axialement au-delà de la partie de fixation (7), d'une couche barrière, notamment comprenant du SiOₓ, sous vide afin d'augmenter l'effet de blocage de pénétration contre au moins un composé chimique et/ou au moins un élément chimique sur une surface interne du canal verseur (4), une pluralité de becs verseurs (3) en plastique étant revêtus simultanément de la couche barrière sous vide dans une chambre de revêtement sous vide, de préférence par un procédé ALD, un procédé CVD ou un procédé PVD,
**caractérisé en ce qu'**
avant d'être revêtus de la couche barrière, les becs verseurs (3) en plastique sont posés sur un support (1) de telle manière que la surface de scellage (8) de chaque bec verseur (3) en plastique est tournée vers le support (1) pendant le revêtement afin d'être masquée contre un revêtement avec la couche barrière, et **en ce qu'**un percement axial (17) du support (1) est assigné à chaque bec verseur (3) en plastique de telle manière que les canaux verseurs (4) sont alignés aux percements (17) et ainsi du gaz de revêtement et/ou du plasma de revêtement coule à travers les ouvertures de passage et les canaux verseurs (4) pendant le revêtement sous vide.

2. Procédé selon la revendication 1,
**caractérisé en ce que**
les surfaces de scellage (8) des becs verseurs (3) en plastique sont formées par une partie de fixation (7) respective qui présente un contour angulaire, notamment perpendiculaire, préférablement sous forme d'un petit bateau et **en ce que** les parties de fixation (7) des becs verseurs (3) en plastique sont reçues dans des renfoncements (2) du support (1), les renfoncements préférablement ayant une pente d'entrée, et les surfaces de scellage (8) font face, préférablement de manière radiale par rapport à une étendue axiale des canaux verseurs (4), à une paroi de renfoncement (15) respective.

3. Procédé selon la revendication 2,
**caractérisé en ce qu'**
une taille de fente (x), notamment radiale, préférablement moyenne, d'entre 0,1 mm et 1 mm, préférablement entre 0,1 mm et 0,7 mm, plus préférablement entre 0,1 mm et 0,5 mm, de préférence particulière entre 0,15 mm et 0,4 mm, encore plus préférablement entre 0,2 mm et 0,3 mm, est sélectionnée entre les surfaces de scellage (8) et les parois de renfoncement (15) et/ou **en ce que** les becs verseurs (3) en plastique sont insérés dans les renfoncements (2) par au moins 50 %, préférablement au moins 80 %, de préférence particulière 100 % de l'étendue verticale de leurs parties de fixation (7).

4. Procédé selon l'une quelconque des revendications précédentes,
**caractérisé en ce que**
les becs verseurs (3) en plastique, sur leur partie de fixation (7) respective, ont chacun un épaulement annulaire circonférentiel faisant saillie dans la direction radiale, notamment un bourrelet annulaire ou une collerette annulaire, par lequel les becs verseurs (3) en plastique s'appuient sur le support (1), notamment sur un bord d'ouverture du renfoncement, notamment de manière axiale et/ou radiale par rapport à l'étendue axiale du canal verseur (4) respectif afin de fermer une fente formée de manière axialement adjacente à la collerette annulaire, notamment au-dessous de la collerette annulaire, entre la surface de scellage (8) et le support (1).

5. Procédé selon l'une quelconque des revendications précédentes,
**caractérisé en ce que**
les becs verseurs (3) en plastique, sur leur partie de fixation (7), ont un épaulement annulaire circonférentiel faisant saillie vers le bas dans la direction axiale et/ou radialement, notamment un bourrelet annulaire ou une collerette annulaire, par lequel les becs verseurs (3) en plastique s'appuient sur le support (1), notamment sur un fond (20) du renfoncement, notamment de manière axiale et/ou radiale par rapport à l'étendue axiale du canal verseur (4) afin de fermer une fente formée au-dessous de la collerette annulaire entre la surface de scellage (8) et le support (1).

6. Procédé selon l'une quelconque des revendications précédentes,
**caractérisé en ce que**
par rapport aux becs verseurs (3) en plastique, les percements (17) sont dimensionnés de telle manière que la section transversale libre de chaque percement (17) correspond à au moins 60 %, préférablement au moins 80 %, plus préférablement au moins 90 % de la face de projection axiale de la partie de fixation (7) du bec verseur (3) en plastique associé.

7. Procédé selon l'une quelconque des revendications précédentes,
**caractérisé en ce que**
des broches de centrage (16), préférablement pénétrant les percements (17) du support (1), sont assignées aux becs verseurs (3) en plastique afin de les centrer par rapport au support (1), préférablement part rapport aux parois circonférentielles des renfoncements (2), préférablement à une station de pose à laquelle le support (1) est transporté pour la pose des becs verseurs (3) en plastique et à partir de laquelle le support (1) est transporté dans la chambre de revêtement après que les becs verseurs (3) en plastique ont été posés sur le support.

8. Procédé selon la revendication 7,
**caractérisé en ce que**
les canaux verseurs (4) des becs verseurs (3) en plastique sont posés sur les broches de centrage (16) à l'aide de préhenseurs, notamment de préhenseurs à vide et/ou de pinces de préhension, préférablement de telle manière qu'après la pose les becs verseurs (3) en plastique glissent le long des broches de centrage (16) dans les renfoncements (2) associés et qu'ensuite les broches de centrage (16) sont retirées des canaux verseurs (4), préférablement à travers les percements (17) dans le support (1).

9. Procédé selon l'une quelconque des revendications 7 ou 8,
**caractérisé en ce que**
des préhenseurs individuels ou des groupes de préhenseurs sont montés, notamment de manière flottante, de manière à être déplaçable l'un par rapport à l'autre perpendiculairement à l'étendue longitudinale des broches de centrage (16) de sorte que les plusieurs préhenseurs ou les groupes de préhenseurs peuvent être alignés simultanément par rapport aux broches de centrage (16) conjointement avec les becs verseurs (3) en plastique.

10. Procédé selon l'une quelconque des revendications 7 à 9,
**caractérisé en ce que**
les préhenseurs portant les becs verseurs (3) en plastique sont d'abord positionnés par rapport aux broches à l'aide de moyens de centrage mécaniques, notamment à l'aide de cônes d'entrée terminaux des broches de centrage (16), avant que les préhenseurs descendent les becs verseurs (3) en plastique.

11. Procédé selon l'une quelconque des revendications précédentes,
**caractérisé en ce qu'**
après être revêtus, les becs verseurs (3) en plastique sont fixés de manière étanche aux liquides à une gaine de récipient d'emballage, notamment à un film de sachet stand up, en scellant, notamment de manière thermique, la gaine de récipient d'emballage à la surface de scellage (8).

12. Procédé selon l'une quelconque des revendications précédentes,
**caractérisé en ce que**
les becs verseurs (3) en plastique sont revêtus en ligne avec la production des becs verseurs (3) en plastique, notamment par moulage par injection, et **en ce que** les becs verseurs (3) en plastique sont posés sur le support (1) dans l'état où ils sont encore chauffés à une température supérieur à la température ambiante à la suite de la production, préférablement à une température supérieure à 50°C, plus préférablement supérieure à 80 °C.

13. Dispositif pour mettre on oeuvre un procédé selon l'une quelconque des revendications précédentes, comprenant une chambre de revêtement sous vide pour revêtir simultanément une pluralité de becs verseurs (3) en plastique d'une couche barrière respective sous vide et des moyens de manutention destinés chacun à poser plusieurs becs verseurs (3) en plastique sur un support (1) qui préférablement circule sur le dispositif entre différentes stations,
**caractérisé en ce que**
les moyens de manutention sont configurés de telle manière qu'ils posent les becs verseurs (3) en plastique sur le support (1) de telle manière que les surfaces de scellage (8) des becs verseurs (3) en plastique sont tournées vers le support (1) pendant le revêtement afin d'être masquées contre le revêtement avec la couche barrière, et **en ce que** le support (1) a une pluralité de percements (17) qui sont configurés et disposés de telle manière que du gaz de revêtement et/ou du plasma de revêtement peut couler à travers les canaux verseurs (4) pendant le revêtement.

14. Dispositif selon la revendication 13,
**caractérisé en ce que**
le support (1) a une pluralité de renfoncements (2) qui servent chacun à recevoir un des becs verseurs (3) en plastique à revêtir.
